# EUROPEAN PATENT APPLICATION

(11) **EP 4 576 948 A1**
(43) Date of publication of application: **25.06.2025**
(21) Application number: 24221675.2
(22) Date of filing: 19.12.2024
(51) Int. Cl.: H05K 1/03, H01L 23/13, H01L 23/15, H05K 1/18, H01L 21/48, H01L 23/498, H05K 3/40, H05K 3/42, H05K 3/46

(54) **A SUBSTRATE INCLUDED IN A PACKAGING SUBSTRATE AND HAVING A PLATE SHAPE AND PACKAGING SUBSTRATE**

(30) Priority: 24.12.2023 US 202363614617 P
(71) Applicant: Absolics Inc., Covington, GA 30014 (US)
(72) Inventor: YUN, SeHan, Covington, Georgia, 30014 (US); LEE, Bongyeol, Covington, Georgia, 30014 (US)
(74) Representative: BCKIP Part mbB

(57) **Abstract**

The present disclosure relates to a substrate, a packaging substrate, and a method for manufacturing the substrate. A substrate according to the present disclosure is a plate-shaped substrate included in a packaging substrate, including a glass substrate having a first face and a second face facing each other, the glass substrate having a cavity portion; and a cavity extension portion; disposed thereon, the cavity portion having an accommodation space therein and having at least one corner, the corner being a virtual line where extensions of two adjacent sides of the accommodation space meet, the cavity extension portion being disposed at the corner and having a corner space connected with the accommodation space. In this way, a sufficient distance between the cavity extension and the edge of the cavity element can be secured to prevent shorting, and the effect of spreading the stress applied to the glass substrate by the cavity extension can occur to prevent the glass substrate from breaking.

## Description

### BACKGROUND

### 1. Field

This document relates to substrates for packaging substrates, semiconductor packages, methods of manufacturing substrates, and the like.

### 2. Description of Related Art

When building an electronic component, implementing the circuitry on a semiconductor wafer is called the Front-End (FE), and assembling the wafer into a product-ready state is called the Back-End (BE). The latter includes the packaging process.

There are four core technologies in the semiconductor industry that have enabled the rapid development of electronic products in recent years: semiconductor technology, semiconductor packaging technology, manufacturing process technology, and software technology. Semiconductor technology is advancing in various forms, including sub-micron to nano-scale line widths, more than 10 million cells, high-speed operation, and high heat dissipation, but the technology to package them perfectly is relatively weak. Therefore, the electrical performance of semiconductors is often determined by packaging technology and electrical connections rather than the performance of the semiconductor technology itself.

Substrates for packaging may be made of ceramic or resin. Ceramic substrates, such as silicon substrates, have high resistivity or high dielectric constant, making it difficult to mount high-performance, high-frequency semiconductor devices. In the case of resin substrates, it is possible to mount relatively high-performance, high-frequency semiconductor devices. However, there are limitations in reducing the pitch of the wiring.

Recently, silicon or glass can be used as substrates for high-end packaging. By forming through-holes in the silicon or glass substrate and applying conductive materials to the through-holes, the wiring between the device and the motherboard can be shortened and have good electrical characteristics.

Related prior arts includes Korean Patent Publication No. 10-2023-0035258, and Korean Patent Publication No. 10-2017-0067947.

### SUMMARY

An object of the embodiments is to provide a packaging substrate in which a glass substrate is used, a substrate having a cavity expansion portion formed such that a corner region of the cavity portion expands, a method of manufacturing the substrate, and a packaging substrate utilizing the substrate.

Further, an object of the embodiments is to provide a method of manufacturing a packaging substrate having a cavity portion including a cavity extension portion that allows a corner region of the cavity portion to extend through the glass substrate so that a sufficient distance between a corner of the cavity portion and an edge of a cavity element is secured, and to provide a packaging substrate using the method.

To achieve the above objectives, a substrate according to one embodiment is a plate shaped substrate included in a packaging substrate, comprising: a glass substrate having first and second faces facing each other; a cavity portion; and a cavity expansion portion; disposed on the glass substrate.

A cavity portion having an accommodation space therein and having at least one corner, the corner being an virtual line where two neighboring side face extensions of the accommodation space meet, the cavity extension being disposed at the corner and having a corner space connecting with the accommodation space.

When viewed from the first face toward the second face, the first corner is a corner where the cavity extension is disposed of.

An angle between two side faces of the glass substrate at the first corner is greater than 180 degrees.

The corner space is a space in the form of a partially removed glass substrate of the first corner.

The edge of the corner space may have the form of an arc of a circle or an ellipse.

A corner space center angle is an angle between the two side faces and two tangents of the arc.

The corner space center angle of the first corner may be 20 degrees or more.

When viewed from the first face toward the second face, the second corner is a corner where the cavity extension is disposed

An angle between the two side faces of the glass substrate at the second corner is less than 180 degrees.

The corner space is a space in the form of a partially removed glass substrate of the second corner.

The edge of the corner space may have the form of an arc of a circle or an ellipse, and the corner space center angle is an angle between the two side faces and two tangents of the arc.

A corner space center angle of the second corner may be 180 degrees or less.

When viewed from the first face toward the second face, the cavity extension has the form of a circular or elliptical arc.

The arc may have an average radius of 40 µm or more.

The glass substrate may include through glass vias that penetrate the glass substrate in the thickness direction.

The average radius of the arc may be from 0.5 times to 3 times the radius of the through-glass via.

The cavity portion may comprise at least four corners.

The cavity extensions may be disposed in the cavity portion at least four and no more than the number of corners.

The substrate may include electronic elements disposed in the cavity.

The distance between the side face of the accommodation space and the electronic element is D1, and the distance between the side face of the glass substrate of the cavity extension and the electronic element is D2.

D2 may be equal to or greater than D1.

The substrate may include an electronic element disposed in the cavity.

The portions other than the electronic element in the accommodation space and the corner space may be filled with a filling material.

The filling material may include an insulating material, a metallic material, or a heat dissipating material.

D3 is a distance between the end of the cavity extension and the side of the cavity portion and the D3 may be 2 µm or more.

To achieve the above object, a packaging substrate according to an embodiment includes: the substrate described above; an electronic element disposed in the cavity portion; and an upper layer on which an upper redistribution layer for transmitting electrical signals is disposed.

To achieve the above object, a method of manufacturing a substrate according to one embodiment, the method of manufacturing a plate shaped substrate to be included in a packaging substrate.

The method comprises operations of; generating defects for forming a cavity portion and defects for forming a cavity extension portion in a glass substrate having a first and a second face facing each other; and etching the glass substrate to form the cavity portion and the cavity extension portion.

The cavity portion has an accommodation space therein and has at least one corner.

The corner is an virtual line where two neighboring side face extensions of the accommodation space meet.

The cavity extension is disposed at the corner and has a corner space connecting with the accommodation space.

When viewed from the first face toward the second face, the cavity extension may have the form of an arc of a circle or an ellipse.

The glass substrate may include through glass vias that penetrate the glass substrate in the thickness direction.

The average radius of the arc may be from 0.5 times to 5 times the radius of the through-glass via.

### BRIEF DESCRIPTION OF THE DRAWINGS

FIG. 1 is a conceptual diagram illustrating a cross-sectional structure of a packaging substrate, according to an embodiment.
FIGS. 2A and 2B are conceptual diagrams illustrating a cross-sectional structure of a packaging substrate, according to different embodiments.
Fig. 3A is a conceptual diagram illustrating the process of forming the cross-sectional structure of the packaging substrate in Fig. 2A. Similarly, Fig. 3B is a conceptual diagram illustrating the process of forming the cross-sectional structure shown in Fig. 2B.
FIG. 4 is a cross-sectional flowchart illustrating a process for forming a core distribution layer during the manufacturing process of a packaging substrate, according to an embodiment.
FIG. 5 is a cross-sectional flowchart illustrating a process for forming an insulating layer during manufacturing process of a packaging substrate, according to an embodiment.
FIG. 6 is an exemplary diagram illustrating a corner portion of a cavity portion having a radius of curvature and a structure of a cavity element.
FIG. 7 is a diagram illustrating an exemplary structure of a corner portion of a cavity portion and a cavity element created in accordance with an embodiment.
FIG. 8 is a diagram illustrating an exemplary structure of a glass substrate including a cavity portion and a cavity element created in accordance with another embodiment.
FIG. 9 is a diagram illustrating an exemplary structure of a glass substrate including cavity portions created in accordance with another embodiment.
FIGS. 10A, 10B, 10C, and 10D are illustrations of exemplary structures of cavity portions created in accordance with other embodiments.

### DETAILED DESCRIPTION

In order to provide a comprehensive understanding of the methods, apparatus, and/or systems described herein, the following detailed description is provided. However, various modifications, alternatives, and equivalents of the methods, devices, and/or systems described herein will become apparent after understanding what this disclosure presents. For example, the sequence of operations described herein is by way of example only and is not intended to be limiting to the operations described herein. Except for operations that are not necessarily performed in a particular order, the order of operations may be altered based on an understanding of what is disclosed herein. In addition, descriptions of features already known in the art may be omitted for clarity and brevity after understanding the disclosure of this application. However, the omission of such features and their descriptions is not intended to be recognized as general knowledge.

The features described herein may be implemented in different forms and are not to be construed as being limited to the examples described herein. Rather, the embodiments described herein are provided to illustrate some of the many possible ways of implementing the methods, devices, and/or systems described herein that will become apparent after understanding the disclosures of this application.

The terms "first," "second," "third," and the like may be used herein to describe various members, components, regions, layers, or sections, but are not intended to limit the members, components, regions, layers, or sections to these words. Instead, these terms are used for the purpose of distinguishing one member, component, region, layer, or section from another member, component, region, layer, or section. Thus, a first member, component, region, layer, or section referred to in the embodiments described herein may also be referred to as a second member, component, region, layer, or section without departing from the teachings of the embodiments.

Throughout the specification, when an element, such as a layer, region, or substrate, is described as being "on," "connected to," or "coupled to" another element, it may be described as being directly "on," "connected to," or "coupled to" the other element, or it may have one or more other elements interposed between them. In contrast, when an element is described as "directly on", "directly connected to", or "directly joined to" another element, no other element can intervene between them. Similarly, for example, expressions such as "between" and "directly between," and "abutting" and "directly abutting" can also be interpreted as described above.

The terms used in this specification are intended to describe specific examples and are not intended to limit disclosure. The singular form used herein is intended to include the plural form unless the context clearly indicates otherwise. As used herein, the term "and/or" includes any one or a combination of two or more of the relevant list items. The terms "comprising," "consisting of," and "having" as used herein specify the presence of the specified features, numbers, actions, elements, components, and/or combinations thereof, but do not exclude the presence or addition of one or more other features, numbers, actions, elements, components, and/or combinations thereof. The use of the term "may" in this specification with respect to an example or embodiment (e.g., with respect to what an example or embodiment may include or implement) implies that there is at least one example or embodiment that includes or implements such features, but not all examples are limited thereto.

In this application, "B being located on A" means B being placed on top of A, either in direct contact with A or with another layer or structure interposed therebetween, and should not be construed as B being in direct contact with A.

Unless otherwise defined, all terms used herein shall have the same meaning as commonly understood by one of ordinary skill in the art to which the present invention belongs. Terms such as those defined in commonly used dictionaries are to be construed to have meanings consistent with their meaning in the context of the prior art and the present invention and are not to be construed in an idealized or overly formal sense unless expressly defined herein.

In one or more of the examples above, a description of "A and/or B" means "A, B, or A and B".

In one or more of the above examples, terms such as "first," "second," "A," or "B" are used to distinguish identical terms from each other.

In one or more of the above examples, a singular form is contextually interpreted to include the plural as well as the singular, unless otherwise noted.

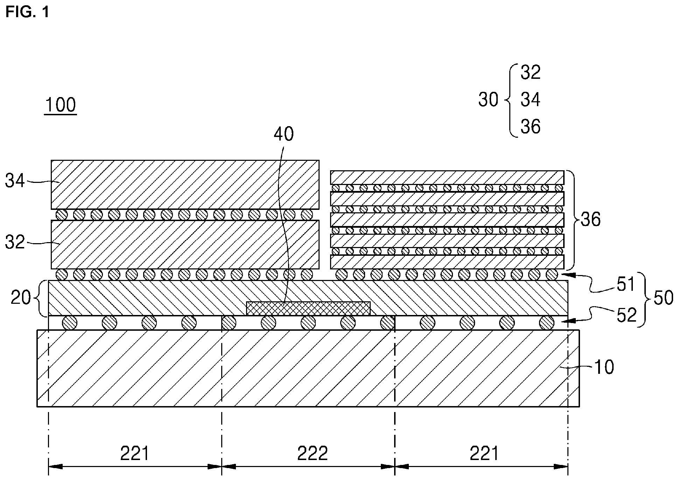

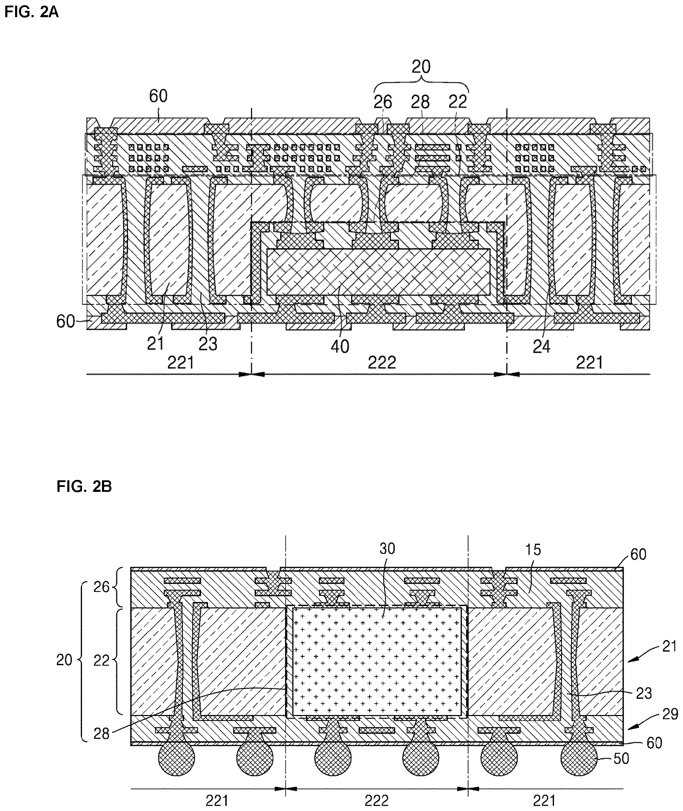

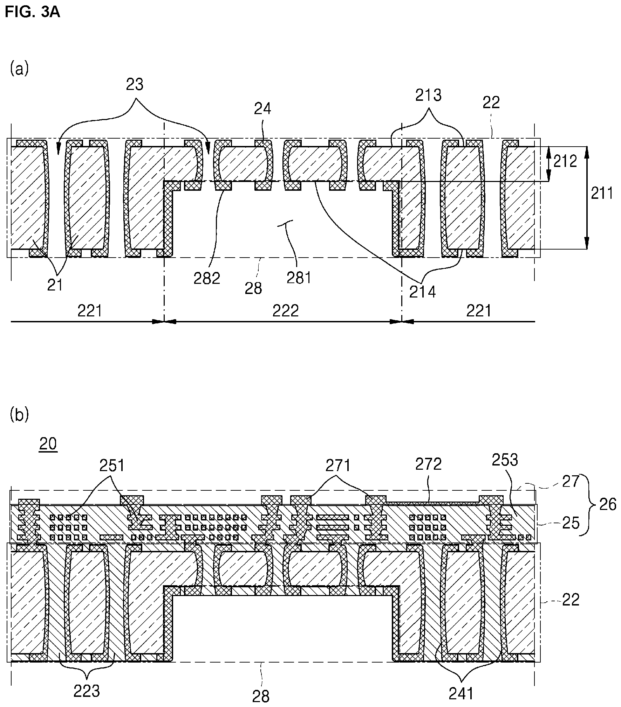

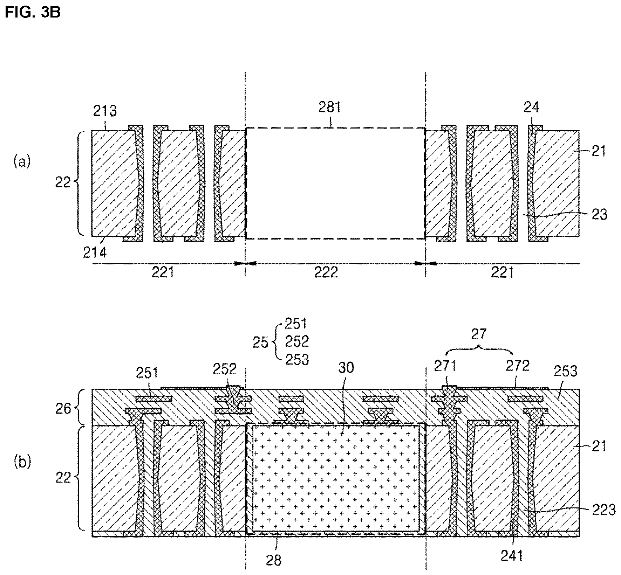

FIG. 1 is a conceptual diagram illustrating a cross-sectional structure of a packaging substrate according to an embodiment, FIGS. 2A and 2B are conceptual diagrams illustrating a cross-sectional structure of a packaging substrate, according to different embodiments, Fig. 3A is a conceptual diagram illustrating the process of forming the cross-sectional structure of the packaging substrate in Fig. 2A, and Fig. 3B is a conceptual diagram illustrating the process of forming the cross-sectional structure shown in Fig. 2B.

To accomplish the above objectives, a semiconductor device 100 according to an embodiment comprises a semiconductor element portion 30 on which one or more semiconductor elements 32, 34, 36 are located; a packaging substrate 20 electrically connected to the semiconductor elements; and a motherboard 10 electrically connected to the packaging substrate 20 and transmitting external electrical signals to and from connecting the semiconductor element 32, 34, 36 with each other.

The packaging substrate 20, according to one embodiment, comprises a core layer 22, an upper layer 26 located on a first face of the core layer 22, and a cavity portion 28 in which a cavity element 40 may be located.

The semiconductor element portion 30 refers to an element mounted on a semiconductor element and is mounted on the packaging substrate 20 by means of a connection electrode or the like.

Specifically, the semiconductor element portion 30 may be applied to, for example, a computing element (first semiconductor element: 32, second semiconductor element: 34) such as a CPU or GPU, a memory element (third semiconductor element, 36) such as a memory chip, etc.

The mother board 10 may be a motherboard such as a printed circuit board, a printed wiring board, or the like.

The packaging substrate 20 may optionally further comprise a bottom layer 29 positioned below the core layer.

The core layer 22 may comprise a glass substrate 21, a plurality of core vias 23, and a core distribution layer 24. The glass substrate 21 comprises a first zone 221 having a first thickness and a second zone 222 having a second thickness adjacent to the first zone 221 and having a thickness less than the first thickness or having a zero thickness. The plurality of core vias 23 penetrates the glass substrate 21 in a thickness direction. The core distribution layer 24 is located on a surface of the glass substrate 21 or core vias 23 and electrically connecting, via the core vias 23, a first face 213 of the glass substrate 21 and a second face 214 facing the first face 213((a) of Fig 3A.)

The second region 222 of the core layer 22 may serve as a cavity structure.

Within the same region, the glass substrate 21 has a first face 213 and a second face 214 that face each other, and these two faces are substantially parallel to each other and have a constant thickness throughout the glass substrate 21.

The inner space 281 formed by the difference in thickness of the first zone 221 and the second zone 222 serves to house some or all of the cavity elements 40. FIGS. 2B and 3B illustrate a full cavity with the glass substrate of the second zone removed. However, embodiments are not limited to this, and half-cavities are also applicable. An example of a half-cavity is shown in FIGS. 2A and 3A.

The glass substrate 21 may comprise a core via 23 through the first face 213 and the second face 214. The core vias 23 may be formed in both the first region 221 and the second region 222, provided that the second thickness is non-zero, and may be formed in any desired pitch and pattern. Alternatively, if the second thickness is zero, the core via 23 may be formed in the first zone 221 and may be formed in any desired pitch and pattern.

As a packaging substrate for semiconductor devices, silicon substrates and organic substrates have traditionally been applied in a laminated form. In the case of silicon substrates, due to the nature of semiconductors, parasitic elements may occur when applied to high-speed circuits, and power losses are relatively high. In addition, organic substrates require a large area to form more complex distribution patterns, which is inconsistent with the trend of miniaturization of electronic devices. In order to form a complex distribution pattern within a certain size, pattern refinement is practically necessary, but there were practical limitations in pattern refinement due to the characteristics of materials such as polymers applied to organic plates.

In an embodiment, a glass substrate 21 is applied as a support for the core layer 22 as a way to address these issues. In addition, a core via 23 formed through the glass substrate 21 is applied along with the glass substrate 21 to provide the packaging substrate 20 with shorter electrical flow lengths, more miniaturization, faster response, and lower loss characteristics.

The glass substrate 21 is preferably a glass substrate applied to semiconductors, and for example, a borosilicate glass substrate, an alkali-free glass substrate, and the like may be applied, but is not limited thereto.

The core via 23 penetrates the glass substrate 21. The core via 23 may be formed in such a way as to remove a predetermined area of the glass substrate 21, in particular by etching the plate glass by physical and/or chemical means.

Specifically, the formation of the core via 23 may be accomplished by forming defects (inclusions) on the surface of the glass substrate by means of a laser or the like, followed by chemical etching, laser etching, and the like, but is not limited to.

The core via 23 may be 100 to 3,000 in number, 100 to 2,500 in number, 225 to 1,024 in number, or 225 to 1,024 in number based on a unit area (1 cm x 1 cm) of the glass substrate 21. When these pitch conditions are met, the formation of an electrically conductive layer or the like and the performance of the packaging substrate may be improved.

The core distribution layer 24 comprises a core distribution pattern 241, which is an electrically conductive layer electrically connecting the first and second faces of the glass substrate via through vias, and a core insulation layer 223 surrounding the core distribution pattern. The core layer 22 has an electrically conductive layer formed therein through the core vias, which acts as an electrical pathway across the glass substrate 21 and may connect the top and bottom of the glass substrate over a relatively short distance, resulting in faster electrical signal transfer and low loss. The electrically conductive layer may be, for example, but not limited to, a copper plating layer.

The cavity portion 28 is substantially circular, triangular, square, hexagonal, octagonal, cross-shaped, or otherwise non-limiting in shape.

The cavity element 40 may be generally cylindrical, cuboidal, or polygonal in shape.

The cavity portion 28 may comprise a cavity distribution pattern, which is an electrically conductive layer electrically connecting the cavity element 40 and the core distribution layer 24, and an insulating layer surrounding the cavity distribution pattern.

On the other hand, the cavity portion according to another embodiment may be implemented in a form that penetrates the first face 213 and the second face 214 of the glass substrate 21. In this case, the cavity portion may be formed according to the same process as the formation process of the core vias 23 and may differ from the core vias 23 in the area and shape that it penetrates the glass substrate 21.

In such an embodiment, an insulating layer may be generated in the cavity portion after it is arranged in the cavity element 40, i.e., an insulating layer may be generated in the cavity portion through the process of generating the core insulation layer 223 described above.

The core distribution pattern 241 may be patterned to be electrically coupled to the cavity element 40.

The cavity element 40 may comprise an active element, such as a transistor, or a passive element, such as a power transfer element, such as a multilayer ceramic capacitor (MLCC).

If an element such as a transistor, which plays a role in converting electrical signals between the motherboard and the semiconductor element portion to an appropriate level, is applied to the cavity element 40, the packaging substrate 20 may be formed in a form in which a transistor or the like is applied within the packaging substrate 20, thereby providing a semiconductor device 100 having a more efficient and faster speed.

In addition, power transfer elements, such as multilayer ceramic capacitors (MLCCs), play an important role in the performance of semiconductor devices. It is common for at least 200 or more power transfer elements, which are passive elements, to be applied to a semiconductor device, and their performance in transferring power is also affected by the characteristics of the electrically conductive layer surrounding the element. In one embodiment, non-circular shaped core vias may be applied where a low resistance electrically conductive layer is required, such as in power transfer elements.

On the other hand, the cavity element 40 may be applied by inserting a passive element such as a capacitor individually, or a group of elements comprising a plurality of passive elements in a form embedded between an insulator layer (cavity element insulation layer), and the electrodes may be formed to be exposed and inserted into the cavity element. The latter option is more workable for packaging substrate fabrication and more favorable for ensuring that the insulating layer is sufficiently and reliably located in the space between the complex elements.

The glass substrate 21 plays an intermediate role, an intermediary role, connecting the semiconductor element portion 30 and the motherboard 10 on the upper and lower sides, respectively, and the core via 23 acts as a passageway for transmitting electrical signals therebetween, thereby enabling smooth signal transmission. For the purpose of distinguishing from the core via of the second zone 222 described later, the core via disposed in the first zone 221 will be referred to as the first zone core via 231.

The upper layer 26 is positioned on the first face 213.

The upper layer 26 may comprise an upper distribution layer 25 and an upper surface connection layer 27 positioned on the upper distribution layer 25, and the uppermost surface of the upper layer 26 may be protected by a cover layer 60 having an opening formed through which the contact electrodes of the semiconductor element may directly contact.

The upper distribution layer 25 may comprise an upper insulation layer 253 positioned on the first face; and an upper distribution pattern 251 embedded in the upper insulation layer 253 as an electrically conductive layer having a predetermined pattern and electrically connecting at least a portion thereof to the core distribution layer 24. The upper distribution layer 25 disposed above and below each other may be connected to each other via blind vias 252.

The upper insulation layer 253 may be applied as an insulator layer to a semiconductor device or packaging substrate, and may be, for example, an epoxy-based resin containing fillers, but is not limited to.

The insulator layer may be formed by forming a coating layer and curing it, or it may be formed by laminating an uncured or semi-cured insulator film to the core layer 22 and curing it. In this case, by applying a pressure-sensitive lamination method or the like, the insulator may be embedded into the space inside the core vias 23 and the process may proceed efficiently.

In some embodiments, the plurality of insulating layers may be stacked and substantially indistinguishable between the insulating layers, and the plurality of insulating layers are collectively referred to as the upper insulating layer. Additionally, the core insulation layer 223 and the upper insulation layer 253 may be prepared with the same insulating material, in which case the boundary between them may be substantially indistinguishable. Alternatively, in other implementations, the boundaries of the insulator layers may be created by setting different pressures and temperatures to cure the multiple insulator layers.

The upper distribution pattern 251 refers to an electrically conductive layer located within the upper insulation layer 253 in a preset shape, which may be formed, for example, in a build-up layer method. Specifically, upper distribution pattern 251 may be formed by forming an insulator layer, removing an unnecessary portion of the insulator layer, forming an electrically conductive layer by copper plating or the like, optionally removing an unnecessary portion of the electrically conductive layer, forming an insulator layer on top of the electrically conductive layer, removing an unnecessary portion of the insulator layer, forming an electrically conductive layer by plating or the like, and so on, so that the electrically conductive layer is formed in a vertical or horizontal direction in the desired pattern.

Since the upper distribution pattern 251 is located between the core layer 22 and the semiconductor element portion 30, it is formed to comprise a fine pattern in at least a portion thereof so that the transmission of electrical signals to the semiconductor element portion 30 may proceed smoothly and the intended complex pattern may be sufficiently accommodated. In this case, the fine patterns may have a width and spacing of less than 4 µm, 3.5 µm or less, 3 µm or less, 2.5 µm or less, or 2.3 µm. The width and spacing may be 1 µm or more (hereinafter, the description of the fine patterns will be the same).

The upper surface connection layer 27 comprises an upper surface connection pattern 272 electrically connected, at least partially, with the upper distribution pattern 251 and located on the upper insulation layer 253, and a top surface connection electrode 271 electrically connecting the upper surface connection pattern 272 with the semiconductor element portion 30.

The upper surface connection pattern 272 may be located on a first surface of the upper insulation layer 253, or at least a portion thereof may be exposed and embedded in the upper insulating layer. For example, if the upper surface connection pattern is located on one side of the upper insulating layer, the upper insulating layer may be formed by plating or the like, and if the upper surface connection pattern is embedded with a part of it exposed on the upper insulating layer, it may be that a part of the insulating layer or the electrically conductive layer is removed by surface polishing, surface etching, or the like after forming a copper plating layer or the like.

The upper surface connection pattern 272 may comprise at least a portion of a fine pattern, such as the upper distribution pattern 251 described above. The upper surface connection pattern 272 comprising such fine patterns enables a larger number of elements to be electrically connected in a smaller area, allowing for smoother electrical signal connections between elements or to the outside world, and enabling more integrated packaging.

The top surface connection electrode 271 may be directly connected to the semiconductor element portion 30 by terminals or the like or may be connected via an elemental connection portion 51 such as a solder ball.

In the case of a half-cavity substrate, the cavity portion 28 may comprise a cavity distribution layer 282 located above and/or below the second zone 222 and electrically connected to the core distribution pattern 241, and an inner space 281 in which the cavity elements 40 are located. The cavity distribution layer 282 may be formed through the second zone core via 232 (see FIG. 2B).

Specifically, the second region 222 has a thinner thickness of the glass substrate 21 compared to the first region 221, and the cavity element 40 may be located in the inner space 281 formed due to the difference in thickness. Furthermore, the core vias 23 and the core distribution layer 24 formed on the glass substrate 21 serve as an electrical connection structure connecting the cavity element 40 and the semiconductor element portion 30.

Furthermore, as described above, a cavity portion may be created in the form of penetrating the first region 221, i.e., the first face 213 and the second face 214 of the glass substrate 21, rather than the second region 222, and the cavity element 40 may be arranged in the cavity portion.

The packaging substrate 20 is also connected to a motherboard 10. The motherboard 10 may be electrically connected to the core distribution pattern 241 located on at least a portion of the second face 21 of the core layer 22 by terminals of the motherboard 10, either directly or via a board connection portion 52 such as a solder ball. In addition, the core distribution pattern 241 in contact with the motherboard 10 may be connected to the motherboard 10 via a bottom layer (not shown) located at the bottom of the core layer 22. The element connection portion 51 and the board connection portion 52 are collectively referred to as the connection portion 50.

In one example, no substantially additional substrate other than the glass substrate 21 may be applied to the packaging substrate 20 positioned between the semiconductor element portion 30 and the motherboard 10.

Traditionally, an interposer and an organic substrate are laminated together between the element and the motherboard. This multi-operation application is understood to be necessary for at least two reasons: one is that there are scale issues with directly bonding the fine pattern of the element to the motherboard, and the other is that wiring damage may occur during the bonding process or during the driving of the semiconductor device due to differences in thermal expansion coefficients. The embodiment solves these problems by applying a glass substrate having a coefficient of thermal expansion similar to that of a semiconductor device and forming a fine pattern on the first face of the glass substrate and an upper layer thereof having a scale fine enough for mounting the element.

In the following, a method for manufacturing a packaging substrate according to an embodiment of the present invention will be described.

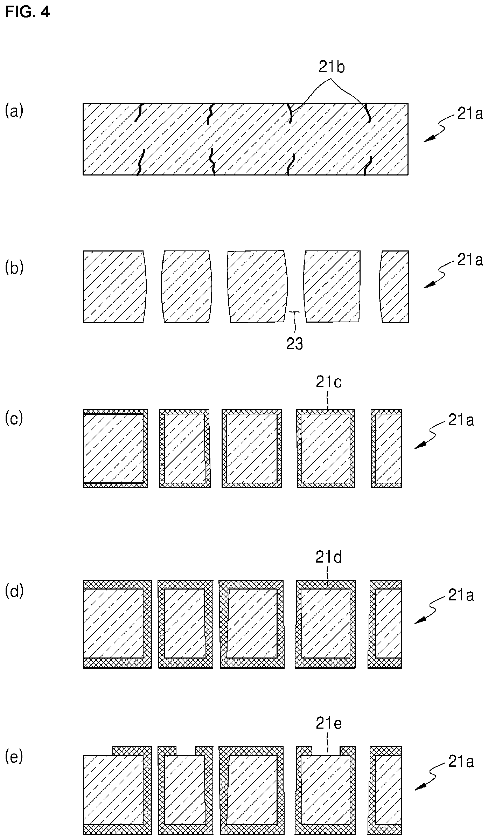

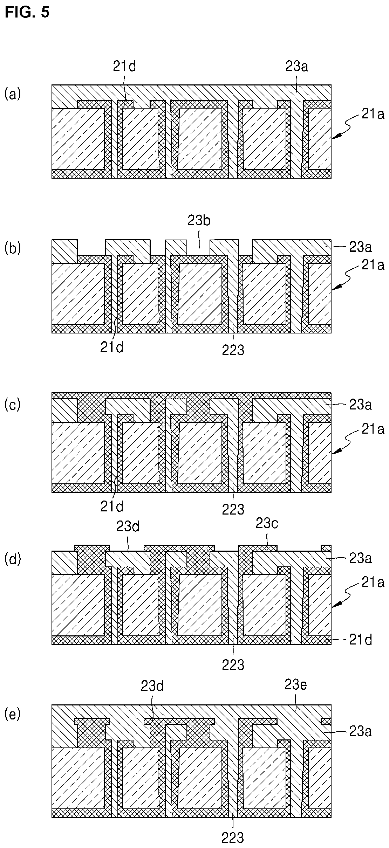

FIGS. 4 and 5 are flowcharts illustrating, in cross-section, the manufacturing process of a packaging substrate according to an embodiment.

First, a glass substrate 21a having a flat first and second face is prepared, as shown in (a) of FIG. 4, and a defect (groove, 21b) is formed on the glass surface at a predetermined position for forming a core via. The glass may be a glass substrate applied to a substrate of an electronic device or the like, and may be, for example, an alkali-free glass substrate or the like, but is not limited thereto. Commercially available products manufactured by manufacturers such as Corning, Schott, AGC, and the like may be applied. The formation of the defects (grooves) can be accomplished by mechanical etching, laser irradiation, or the like.

As shown in (b) of FIG. 4, the glass substrate 21a on which the defect (groove, 21b) is formed is subjected to an etching operation to form the core vias 23 through a physical or chemical etching process. During the etching process, the glass substrate forms vias in the defect areas, and at the same time, the surface of the glass substrate 21a may be etched. A masking film or the like may be applied to prevent such etching of the glass surface, but in consideration of the cumbersome process of applying and removing the masking film, the defective glass substrate itself may be etched, and in this case, the thickness of the glass substrate having the core vias may be somewhat thinner than the thickness of the initial glass substrate.

Then, the core layer preparation operation may be performed by forming an electrically conductive layer 21d on the glass substrate as shown in (c) and (d) of FIG. 4. The electrically conductive layer may be a metal layer comprising, but not limited to, copper metal.

The surface of the glass (comprising the surface of the glass substrate and the surface of the core via) and the surface of the copper metal have different properties, and the adhesion between them is poor. In an embodiment, the adhesion between the glass surface and the metal can be improved by two methods, a dry method and a wet method.

The dry method is a method of applying sputtering, that is, metal sputtering, to form a seed layer 21c on the surface of the glass and the inner diameter of the core via. In the formation of the seed layer, dissimilar metals such as titanium, chromium, nickel, and the like may be sputtered together with copper, and in this case, glass-to-metal adhesion may be improved by an anchor effect in which the surface morphology of the glass and the metal particles interact.

The wet method is a primer treatment method in which a primer layer 21c is formed by pretreatment with a compound having functional groups such as amines. Depending on the degree of adhesion desired, pretreatment with a silane coupling agent may be followed by primer treatment with a compound or particle having an amine functional group. As mentioned above, the support substrate of the embodiment needs to be of high enough performance to form a fine pattern, which should be maintained after the primer treatment. Therefore, if such primer comprises nanoparticles, it is preferred that nanoparticles having an average diameter of 150 nm or less are applied, for example, particles having amine functional groups. The primer layer may be formed by applying a bonding force improver, for example, such as the CZ series of MEC.

The seed layer/primer layer 21c may optionally form the electrically conductive layer with or without removing the portion where the formation of the electrically conductive layer is unnecessary. Furthermore, the seed layer/primer layer 21c may be optionally treated in an activated or deactivated state for metal plating with or without removing the portion where the formation of the electrically conductive layer is necessary or unnecessary to proceed with the subsequent process. For example, the activation or deactivation treatment may be subjected to light irradiation treatment such as a laser of a certain wavelength, chemical treatment, or the like. The formation of the metal layer may comprise, but is not limited to, copper plating methods applied in the manufacture of semiconductor devices.

As shown in (e) of FIG. 4, a portion of the core distribution layer may be removed if not required, and after the seed layer is partially removed or inactivated, metal plating may be performed to form an electrically conductive layer in a predetermined pattern to form the etching layer 21 e of the core distribution layer.

FIG. 5 illustrates manufacturing operations to form an insulating layer and an upper layer pattern, according to one embodiment.

As shown in (a) of FIG. 5, the core via may be subjected to an insulating layer formation operation in which the void space is filled with an insulating layer after the formation of the core distribution layer, which is an electrically conductive layer. In this case, the insulating layer applied may be made in the form of a film, for example, by pressure sensitive lamination of the insulating layer in the form of a film. By performing such pressure-sensitive lamination, the insulating layer may be sufficiently impregnated into the void space inside the core vias to form a core insulating layer without void formation.

(b) through (e) of FIG. 5 illustrate the upper layer manufacturing operations.

The operation of manufacturing the upper layer is to form an upper layer comprising an upper insulating layer and an upper layering pattern on the core layer. The upper insulating layer may be formed by coating a resin composition forming the insulating layer 23a or by laminating an insulating film, and the simplest method is to laminate an insulating film. The lamination of the insulating film may be carried out by laminating the insulating film and curing it, in which case, by applying a pressure sensitive lamination method, the insulating resin may be sufficiently impregnated even to a layer in which an electrically conductive layer is not formed inside the core via. The upper insulating layer is also applied in direct contact with the glass substrate, at least in part, and thus has sufficient adhesion. Specifically, the glass substrate and the upper insulating layer are preferably characterized by an adhesion test value of 4B or more according to ASTM D3359.

The upper distribution pattern may be formed by repeating the process of forming the insulating layer 23a, forming the electrically conductive layer 23c in a predetermined pattern, and etching off the unnecessary parts to form the etching layer 23d of the electrically conductive layer, or, in the case of the electrically conductive layers that are formed adjacent to the insulating layer, forming a blind vias 23b on the insulating layer and then proceeding with the plating process. Dry etching methods such as laser etching, plasma etching, and the like, or wet etching methods using a masking layer and an etching solution, may be applied to form the blind vias.

Then, although not shown, an upper surface connection layer and a cover layer may be formed.

The upper surface connection pattern and the upper surface contact electrode may also be formed by a process similar to the formation of the top layer. Specifically, it may be formed by forming an etching layer of an insulating layer on the insulating layer 23e, forming an electrically conductive layer thereon, and then forming an etching layer of the electrically conductive layer, and so on, but it may also be applied by selectively forming only the electrically conductive layer without applying the method of etching. The cover layer may be formed such that an opening (not shown) is formed at a position corresponding to the upper surface contact electrode so that the upper surface contact electrode is exposed and may be directly connected to an electrical connection or a terminal of the element.

Once the upper layer has been created, the bottom layer may be processed by forming the bottom contact layer and cover layer. The bottom layer and/or the bottom contact layer, and optionally the cover layer (not shown), may be formed in a similar manner to the operations for forming the upper surface connection layer and the cover layer described above.

On the other hand, a cavity portion may be generated in the glass substrate as described above. When the corner portion of the cavity portion is processed to produce the cavity portion, a curved surface may be formed in such a way that the angled corner portion is generally rounded to substantially suppress damage to the angled corner portion and to facilitate the process of producing the cavity portion. The curved surface may have a certain radius of curvature.

When the corner portion of the cavity portion is processed to produce the cavity portion, a curved surface may be formed in such a way that the angled corner portion is generally rounded to substantially suppress damage to the angled corner portion and to facilitate the process of producing the cavity portion. The curved surface may have a certain radius of curvature.

When embedding a cavity element in the cavity, it may be difficult to ensure a sufficient distance between the corner of the cavity element and the corner of the cavity portion due to the curved surface created at the corner. This may increase the short-circuit probability of the embedded cavity element. Furthermore, machining the corners of the cavity portion to be pointed in order to solve the above problem may cause the cavity portion to crack and become vulnerable to breakage. Alternatively, if the size of the cavity portion is substantially larger than the size of the cavity element, the distance between the cavity element and the inner wall surface of the cavity portion may be widened, thereby causing undulation of the packaging substrate. This may also have an adverse effect on the utilization of the surface area of the packaging substrate.

Hereinafter, a structure comprising a glass substrate in a fabricated form that is embedded in a packaging substrate and acts as a support substrate for a plate shaped substrate is referred to and described as a substrate.

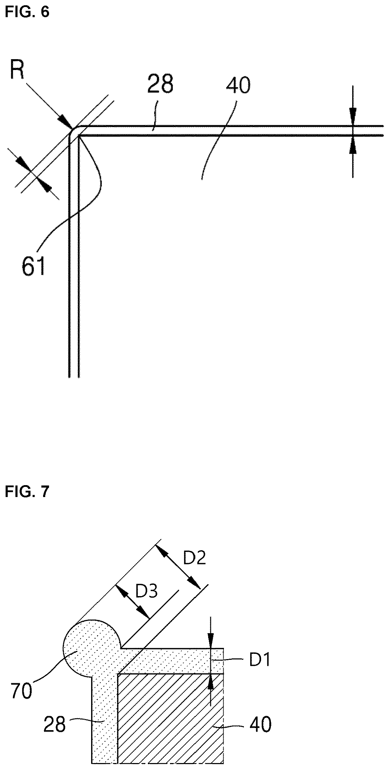

FIG. 6 is an exemplary diagram illustrating a corner portion of a cavity having a radius of curvature and a structure of a cavity element.

Referring to FIG. 6, a cavity portion 28 may be formed in the glass substrate, and a cavity element 40 may be disposed in the cavity portion 28. For example, when the cavity element 40 is disposed in the cavity portion 28, a gap is formed therebetween. Here, when the corners of the cavity portion 28 are processed into curved surfaces, the curved surfaces are formed inwardly from the normal corners.

In this case, the gap between the embedded die, i.e., the corner portion of the embedded cavity element [i.e., the edge of the cavity element] and the cavity corner wall is narrower than the gap in the straight portion. Contact may occur between the corner of the cavity portion 28 and the edge 61 of the cavity element 40, and short circuit of the cavity element may occur if a conductor is disposed therein.

To prevent this, widening the gap between the wall of the cavity portion and the cavity element as a whole makes it easier for voids to form and surface undulations to form when forming the insulating layer.

To avoid the above problems, the present disclosure proposes a method for forming a cavity extension in a corner region of a cavity portion.

Embodiments are proposed in which a corner space is applied as a cavity extension, for example, by expanding a corner region of the cavity portion. This prevents the problem of not securing a sufficient gap between the corner of the cavity portion and the corner of the cavity element due to the curved surface of the corner area that occurs during conventional cavity portion processing, which increases the probability of short circuit, and when filling the cavity portion, the stress applied to the glass substrate may be properly spread through the cavity expansion portion, thereby preventing the glass substrate from breaking.

A substrate according to one embodiment is a plate shaped substrate included in a packaging substrate, comprising a glass substrate 21 having first and second faces facing each other, wherein a cavity portion 28; and a cavity extension portion 70; are disposed on the glass substrate.

The cavity portion 28 having an accommodation space therein and having at least one corner, the corner being a virtual line where two neighboring side extensions of the accommodation space meet, the cavity extension portion 70 being disposed at the corner and having a corner space connecting with the accommodation space.

FIG. 7 is an illustration of an exemplary structure of a cavity portion and cavity extension created in accordance with an implementation. FIG. 7 is a conceptually simplified drawing to illustrate a cavity portion of a packaging substrate created in accordance with an embodiment, to which the teachings described with reference to FIGS. 1 through 5 may be applied.

Referring to FIG. 7, the glass substrate may comprise a cavity extension having an arcshaped extension at the corner of the cavity portion 28 when viewed from above. The cavity extension portion 70 may have a corner space that connects with the accommodation space of the cavity portion 28.

For example, as with the formation of the core via at the corners of the cavity portion 28, a defect may be formed, such as by irradiation with laser energy, and then an etching process may be performed to form the cavity portion 28 and the cavity extension portion 70 together.

The cavity extension portion 70 may be an extended area in the form of a via through the glass substrate 21 at a corner of the cavity portion 28. The corner space may be a space in the form of a partial removal of the glass substrate at the corner.

For example, the edge of the corner space may be in the form of a circle or an arc of an ellipse.

For example, the packaging substrate may comprise an electronic element (cavity element 40) disposed in the cavity portion.

For example, the distance between the cavity wall (side wall) of the cavity extension portion 70 and the edge 61 of the cavity element 40 may be equal to or greater than the distance between the cavity wall on the side of the cavity portion 28 and the cavity element 40.

For example, the distance between a side face of the accommodation space and the electronic element 40 is D1, and the distance between a glass wall surface of the cavity extension portion 70 and the electronic element 40 is D2, and the D2 may be equal to or greater than the D1 (see FIG. 7). For example, the D2 may be 200 µm or less. In this case, the short-circuit prevention effect is excellent.

For example, the distance D3 between the edge of the cavity extension portion 70 and the side of the cavity portion 28 may be 2 µm or more (see FIG. 7). The distance may be 2 µm or more, 5 µm or more, 10 µm or more, 15 µm or more, 20 µm or more, 25 µm or more, 30 µm or more, 35 µm or more, 40 µm or more, 45 µm or more, 50 µm or more, 55 µm or more, or 60 µm or more. The distance may be 120 µm or less, 110 µm or less, 100 µm or less, or 90 µm or less. In this case, it can help to configure an efficient cavity extension while increasing the degree of space utilization of the substrate.

A corner of the cavity portion 28 that comprises a region extending in the form of a via through the glass substrate at the corner of the cavity portion 28 may be referred to as a "Mickey Mouse ears" shaped corner or a "Mickey Mouse ears" corner.

For example, the cavity extension portion 70 may be in the form of a circular or elliptical arc when viewed in the direction from the first face of the glass substrate 21 to the second face. The arc has a radius, and in the case of an ellipse, the average radius is treated as the radius.

The average radius of the arc may be 40 µm or more. The average radius may be 40 µm or more, 45 µm or more, 50 µm or more, 55 µm or more, 60 µm or more, 65 µm or more, 70 µm or more, 75 µm or more, 80 µm or more, 85 µm or more, 90 µm or more, 95 µm or more, or 100 µm or more. The average radius may be 200 µm or less, 180 µm or less, 160 µm or less, or 150 µm or less. In this case, it can help to construct an efficient cavity extension while increasing the degree of space utilization of the substrate.

The glass substrate 21 may comprise through glass vias that penetrate in the thickness direction.

The average radius of the arc may be 0.5 times or more, 0.7 times or more, or 0.9 times or more of the radius of the through-glass via. The average radius may be less than or equal to 3 times, less than or equal to 2.5 times, less than or equal to 2 times, or less than or equal to 1.5 times the radius of the through-glass via. In this case, the substrate may be more efficiently utilized, and the cavity extension may be more efficiently constructed.

While FIG. 7 illustrates an embodiment in which the cavity extension portion 70 is a vialike extended region through the glass substrate 21, the shape of the cavity extension portion 70 proposed herein is not limited to this embodiment. For example, various shapes of corners may be selected to account for interference during embedding of materials into the cavity portion 28. For example, the cavity extension may be formed in the shape of a portion of a circle, a portion of an ellipse, or the like.

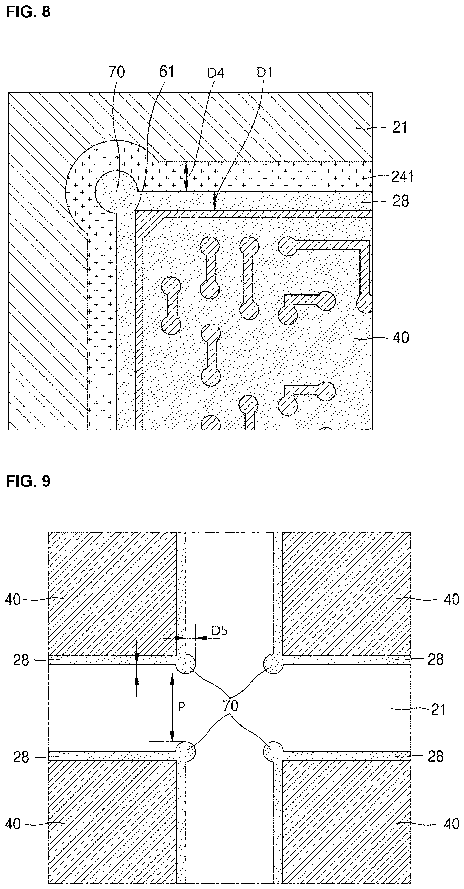

FIG. 8 is a diagram illustrating an exemplary structure of a substrate comprising a cavity and a cavity element created in accordance with another embodiment.

Referring to FIG. 8, the substrate may comprise a cavity portion 28 having a cavity extension portion 70 formed at a corner. An electronic element (cavity element 40) may be disposed in the cavity portion 28.

The inner wall surface of the cavity portion 28 may be an exposed face of a glass substrate. In another example, the inner wall surface of the cavity portion 28 may have an additional layer disposed on the inner wall surface.

In FIG. 8, a core distribution pattern 241 connecting the first and second faces of the glass substrate 21 with a metal layer is illustrated, but a layer having electrical conductivity, such as a heat dissipation layer, may be arranged.

Specifically, one or more cavity elements (electronic elements 40) may be disposed in the inner space of the cavity portion. And the inner space, except for the cavity portion, may be filled with a filling material. The filling material may comprise an insulating material, a metal material, or a heat dissipating material, and two or more distinct materials may be arranged in a predetermined arrangement.

Exemplarily, a metal layer may be disposed on the inner wall surface. Exemplarily, the metal layer may be an electrically conductive layer, and a metal layer such as copper may be applied. In this case, the accommodation space refers to a portion where the electrically conductive layer is excluded. Exemplarily, the thickness of the metal layer is D4, and the distance between the side of the accommodation space and the electronic element is D1 (see FIG. 8).

The portions other than the electronic elements in the accommodation space and the corner space may be filled with a filling material, for example, an insulating material, a metal material, or a heat dissipating material, preferably an insulating material.

The insulating material may comprise a liquid crystal polymer (LCP), an epoxy molding compound (EMC), an Ajinomoto build-up film (ABF), or a modified polyimide (MPI).

FIG. 9 is a diagram illustrating an exemplary structure of a glass substrate comprising cavity portions created in accordance with another embodiment.

Referring to FIG. 9, the glass substrate 21 may comprise two or more cavity portions 28 in which a plurality of cavity extensions 70 are formed. The FIG. 9 illustrates an arrangement of four cavity portions. Specific descriptions of the cavity portions, cavity extensions, and the like are redundant to the description given above, so detailed descriptions are omitted.

As shown in FIG. 9, the cavity extension portions 70 of different cavity portions 28 disposed adjacent to each other may be spaced apart by a certain distance P or more.

When the distance between the side of the cavity portion 28 and the edge of the cavity extension portion 70 is referred to as D5, the P may be more than 1 times, more than 2 times, more than 3 times, or more than 4 times of the D5. Also, the P may be 20 times or less, 16 times or less, 14 times or less, 12 times or less, 10 times or less, 9 times or less, or 8 times or less of the D5. In this case, by securing a gap of a certain distance or more, the cavity frame may be prevented from breaking. In addition, it can help to construct an efficient cavity extension while increasing the degree of space utilization of the substrate.

The P may be 100 µm or more, 110 µm or more, 120 µm or more, or 130 µm or more. Also, the P may be 300 µm or less, 280 µm or less, 260 µm or less, 240 µm or less, or 220 µm or less. In this case, it may be advantageous to prevent breakage of a glass substrate such as a cavity frame. In addition, the substrate may help to organize an efficient cavity extension while stably securing a support function.

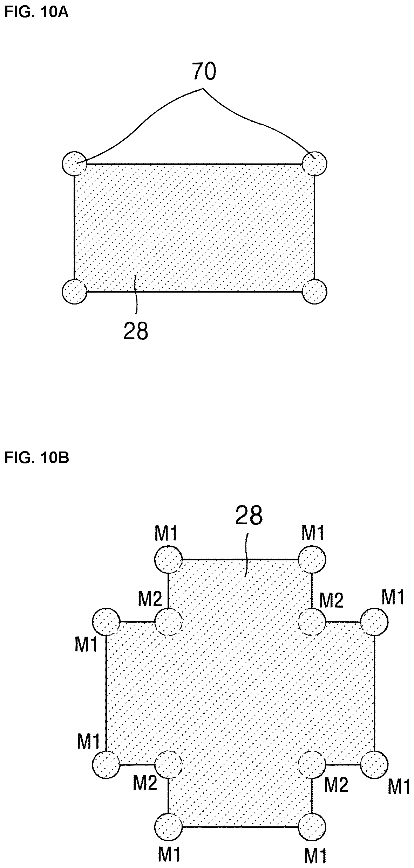

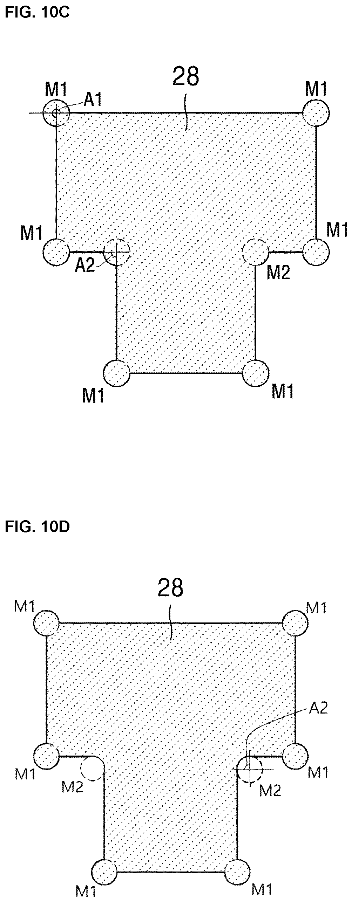

FIGS. 10A, 10B, 10C, and 10D are illustrations of exemplary structures of cavity portions created in accordance with different implementations.

The cavity portion 28 may comprise four or more corners. Exemplarily, one cavity portion may comprise 4, 8, or 12 corners.

The cavity extensions 70 may be disposed in the cavity portion 28 at at least four and no more than the number of corners. The cavity extensions 70 may be disposed in a number equal to or less than the number of corners of the cavity portion 28.

For example, referring to FIG. 10A, a cavity portion 28 having a square shape when viewed from the top surface may be created, and cavity extension portion 70 may be formed at four corners (labeled M1) of the cavity portion 28. Specific descriptions of the cavity portion, the cavity expansion portion, and the like are as described above.

For example, referring to FIG. 10B, a cavity portion 28 in the form of a cross between two squares when viewed from a top view may be created, and cavity extension portion 70 may be formed at 12 corners of the cavity portion 28, i.e., cavity extension portion 70 may be formed at corners where the sides of the cavity portion 28 intersect vertically. In other words, referring to FIG. 10B, a cross-shaped cavity portion 28 may be created, and cavity extension portion 70 may be formed at 12 corners of the cavity portion 28 when viewed from a top view. Specific descriptions of the cavity portion, the cavity extension portion, and the like are as described above.

For example, referring to FIGS. 10C and 10D, a cavity portion 28 in the form of a convex one-sided outgrowth from a square when viewed from a top view may be created, and cavity extension portions 70 may be formed at eight corners of the cavity portion 28, that is, cavity extension portions 70 may be formed at corners where the sides of the cavity portion 28 intersect vertically. Specific descriptions of the cavity portion, the cavity extension portion, and the like are as described above.

The shapes of the cavity extension portion proposed herein are not limited to the above embodiments. For example, various shapes of corners may be selected, considering interference during embedding of materials into the cavity portion. For example, the cavity extension portion may be formed such that the corner region of the cavity extends when viewed from a first face of the glass substrate in a second face direction. For example, the cavity extension portion may be formed such that the corner region of the cavity extends in the form of an arc when viewed from the first face of the glass substrate in the second face direction.

Referring now to FIGS. 10A, 10B, 10C, and 10D, cavity extension portions will be described in more detail. However, the following description of the cavity extension portions is applicable to all of the cavity extension portions described above.

When viewed from the first face in the direction of the second face, the first corner M1 is a first corner in which the cavity extension portion is disposed.

The corner space is a space in which the glass substrate of the first corner (M1) is partially removed.

The first corner M1 is positioned to contact both the first side and the second side, which are the two adjacent walls (edges) of the cavity section. The angle between the first side and the second side at the first corner may be less than 180 degrees. The angle may be 160 degrees or less, 140 degrees or less, 120 degrees or less, 110 degrees or less, 100 degrees or less, or 90 degrees or less. Additionally, the angle may be 30 degrees or more, 40 degrees or more, or 50 degrees or more.

This angle refers to the angle observed from the cavity portion 28. Furthermore, the corner space at the first corner M1 may have its edges in the form of an arc of a circle or an ellipse.

A corner space central angle is the angle between the two side surfaces and the two points of contact with the arc. The corner space central angle is measured from the centroid of the corner space. Additionally, the corner space central angle is measured along the outer contour of the corner space.

The corner space central angle A1 of the first corner M1 may be 120 degrees or more. The angle A1 may also be 160 degrees or more or 180 degrees or more.

The corner space central angle A1 of the first corner M1 may be greater than 180 degrees. The angle A1 may be 200 degrees or more, 235 degrees or more, or 260 degrees or more. The angle may be 320 degrees or less.

When viewed from the first side toward the direction of the second side, the second corner M2 is another example of a corner where the cavity extension is positioned.

The second corner M2 is positioned to contact both 2-1 surface and 2-2 surface, which are the two adjacent walls (edges) of the cavity portion. The angle between the 2-1 surface and the 2-2 surface at the second corner may be greater than 180 degrees. The angle may be 160 degrees or less, 140 degrees or less, 120 degrees or less, 110 degrees or less, 100 degrees or less, or 90 degrees or less. The angle may also be 30 degrees or more, 40 degrees or more, or 50 degrees or more. This angle refers to the angle observed from the cavity portion 28. Additionally, the corner space at the second corner M2 may have its edges in the form of an arc of a circle or an ellipse.

The cavity protrusion of the second corner M2 may have a shape that protrudes from the cavity portion toward the glass substrate side (see Fig. 10C). The centroid of the cavity protrusion may be located within the cavity portion.

The angle A2 of the glass substrate face of the two sides at the second corner M2 is less than 180 degrees. The angle A2 may be less than 180 degrees, 160 degrees or less, 140 degrees or less, 120 degrees or less, 110 degrees or less, or 100 degrees or less. The angle A2 may be 10 degrees or more, or 20 degrees or more.

In another embodiment, referring to FIG. 10D, the first corner M1 may be arranged with the cavity extension portion described above, and the second corner M2 may be chamfered to remove the angled glass portion or to make it a substantially curved surface.

In the case of a curved surface, the radius of curvature may exemplary be 35 µm or more, or 60 µm or more. The radius of curvature may be, for example, 200 µm or less.

The centroid of the cavity protrusion may be located outside the cavity section.

The corner space center angle A2 of the second corner M2 may be 180 degrees or less. The corner space center angle A2 of the second corner M2 may be 170 degrees or less, 160 degrees or less, 140 degrees or less, 120 degrees or less, 110 degrees or less, or 100 degrees or less. The corner space center angle A2 may be 2 degrees or more, 5 degrees or more, 10 degrees or more, or 20 degrees or more.

Embodiments may provide sufficient spacing between the walls of the cavity extension and the corners of the cavity elements to avoid problems that increase the probability of shorting and may properly spread the stresses applied to the glass substrate through the cavity extension to achieve the effect of preventing the glass substrate from breaking.

A packaging substrate according to an embodiment is a glass substrate having a cavity extension as described above. The packaging substrate comprises a substrate as described above, an electronic element disposed in the cavity portion; and an upper layer disposed on the substrate and carrying electrical signals. The packaging substrate may further comprise a bottom layer. Specific descriptions of the packaging substrate, the cavity portion, the cavity extension portion, and the like are redundant with the above descriptions, so specific descriptions will be omitted. Also, specific descriptions of the upper layer, the bottom layer, and the like are redundant with the above descriptions, so specific descriptions are omitted.

The present disclosure also proposes manufacturing methods for generating packaging substrates according to embodiments. For example, a manufacturing method for generating a packaging substrate according to an embodiment of the present disclosure may comprise the following.

For example, a cavity portion 28 may be created in the glass substrate 21 having first and second faces facing each other. The cavity portion 28 may be formed in the form of a recessed surface in which only one of the first or second face is open. The cavity portion 28 may be formed in the form of a recessed surface in which only one of the first or second face is open to provide space for an element to be disposed of. Alternatively, the cavity portion 28 may be recessed with openings toward either the first or the second face of the glass substrate 21 or may be recessed through both the first and the second faces to provide space for an element to be disposed of.

Subsequent to or concurrent with the cavity portion formation, a cavity extension portion 70 may be formed in the corner region of the cavity portion 28.

A method for manufacturing a plate shaped substrate included in a packaging substrate, comprises operations of; creating defects for forming a cavity portion and defects for forming a cavity extension portion in a glass substrate having first and second faces facing each other; and etching the glass substrate to form the cavity portion and the cavity extension portion.

The cavity portion may further comprise an operation of mounting an electronic element.

The substrate manufactured in this way can prevent the problem of increasing the probability of shorting by securing a sufficient gap between the wall of the cavity extension and the corner of the cavity element and can achieve the effect of preventing the glass substrate from breaking by properly spreading the stress applied to the glass substrate through the cavity extension.

The above-described disclosure has been described with reference to the embodiments shown in the drawings, but these are exemplary only, and those having ordinary knowledge in the art will understand that various modifications and variations of the embodiments are possible from them. In other words, the scope of the disclosure is not limited to the embodiments described above, but also to various modifications and improvements of the embodiments and embodiments of those skilled in the art utilizing the basic concepts of the embodiments defined in the following claims. Accordingly, the true technical scope of the disclosure is to be determined by the technical ideas of the appended claims.

## Claims

1. A substrate included in a packaging substrate and having a plate shape, comprising:
a glass substrate having a first face and a second face facing each other;
wherein the glass substrate comprises a cavity portion and a cavity extension portion;
the cavity portion has an accommodation space inside and one or more corners;
the corner is a virtual line where extensions of two adjacent side faces of the accommodation space meet; and
the cavity extension portion is disposed at the corner and has a corner space connected to the accommodation space.

2. The substrate of claim 1,
wherein, when viewed from the first face toward the second face, a first corner is a corner where the cavity extension portion is disposed;
the glass substrate side angle of the two side faces at the first corner exceeds 180 degrees;
the corner space is a space formed by partially removing the glass substrate of the first corner; the edge of the corner space has a shape of an arc of a circle or an ellipse;
a corner space central angle is an angle between the two side faces and two contact points with the arc; and
the corner space central angle of the first corner is 20 degrees or more.

3. The substrate of claim 1 or claim 2,
wherein, when viewed from the first face toward the second face, a second corner is one corner where the cavity extension portion is disposed; and
the glass substrate side angle of the two side faces at the second corner is less than 180 degrees.

4. The substrate of claim 3,
wherein the corner space is a space formed by partially removing the glass substrate of the second corner;
the edge of the corner space has a shape of an arc of a circle or an ellipse;
a corner space central angle is an angle between the two side faces and two contact points with the arc; and
the corner space central angle of the second corner is 180 degrees or less.

5. The substrate of any one from claim 1 to claim 4,
wherein, when viewed from the first face toward the second face, the cavity extension portion has a shape of an arc of a circle or an ellipse; and an average radius of the arc is 40 µm or more.

6. The substrate of claim 5,
wherein the glass substrate comprises a glass through via penetrating in a thickness direction; and the average radius of the arc is 0.5 to 3 times a radius of the glass through via.

7. The substrate of any one from claim 1 to claim 6,
wherein the cavity portion comprises four or more corners; and the cavity extension portion is disposed at the cavity portion in a number of four or more and less than or equal to the number of the corners.

8. The substrate of any one from claim 1 to claim 7,
wherein the substrate comprises an electronic element disposed at the cavity portion;
a distance between the side face of the accommodation space and the electronic element is D1; a distance between a glass wall face of the cavity extension portion and the electronic element is D2; and
the D2 is equal to or greater than the D1.

9. The substrate of any one from claim 1 to claim 8,
wherein the substrate comprises an electronic element disposed at the cavity portion;
a portion other than the electronic element in the accommodation space and the corner space is filled with a filling material; and
the filling material comprises an insulating material, a metal material, or a heat dissipating material.

10. The substrate of any one from claim 1 to claim 9,
wherein a distance D3 between a terminal of the cavity extension portion and the side face of the cavity portion is 2 *µ*m or more.

11. A packaging substrate, comprising:
a substrate according to any one from claim 1 to claim 10;
an electronic element disposed at the cavity portion; and
an upper layer on which an upper redistribution layer for transmitting an electrical signal is disposed.
